Europäisches Patentamt

(19) European Patent Office

Office européen des brevets

(11) Publication number: **0 037 285**
**B1**

(12) **EUROPEAN PATENT SPECIFICATION**

(45) Date of publication of patent specification: **08.06.88**

(51) Int. Cl.⁴: **G 11 C 11/40, G 11 C 8/00**

(21) Application number: **81301402.4**

(22) Date of filing: **31.03.81**

(54) **A memory device, more particularly word line drive circuitry for a memory device.**

(30) Priority: **01.04.80 JP 42489/80**

(43) Date of publication of application:
**07.10.81 Bulletin 81/40**

(45) Publication of the grant of the patent:
**08.06.88 Bulletin 88/23**

(84) Designated Contracting States:
**DE FR GB**

(56) References cited:
**EP-A-0 019 988**
**US-A-3 541 531**
**US-A-3 703 711**

**IBM TECHNICAL DISCLOSURE BULLETIN, vol.
22, no. 8B, January 1980, pages 3736-7, New
York (USA); K. HEUBER et al.: "Two-stage
decoder circuit"**

**IBM TECHNICAL DISLCOSURE BULLETIN, vol.
13, no. 6, November 1970, page 1726, New
York (USA); H.A.GELLER et al.: "Bilevel
powered driver"**

(73) Proprietor: **FUJITSU LIMITED**
**1015, Kamikodanaka Nakahara-ku
Kawasaki-shi Kanagawa 211 (JP)**

(72) Inventor: **Toyoda, Kazuhiro
39-1433, Sakuradai Midori-ku
Yokohama-shi Kanagawa 227 (JP)**
Inventor: **Shimada, Haruo
999-273-506, Mogusa Hino-shi
Tokyo 191 (JP)**

(74) Representative: **Sunderland, James Harry et al
HASELTINE LAKE & CO Hazlitt House 28
Southampton Buildings Chancery Lane
London WC2A 1AT (GB)**

(56) References cited:
**Tietze, Schenk "Halbleiter-Schaltungstechnik",
3rd edition, 1974, Springer Verl. Berlin (DE), p.
114-117**

## Description

This invention relates to a memory device, more particularly word line drive circuitry for a memory device, for example a random access memory comprising a plurality of memory cells each of which has a flip-flop circuit in which a pair of transistors are cross-connected.

A random access memory device wherein a plurality of memory cells, each having a basic structure comprising a flip-flop circuit in which a pair of bipolar transistors are cross-connected, are arranged in the form of matrix is generally known as providing a high speed RAM (Random Access Memory).

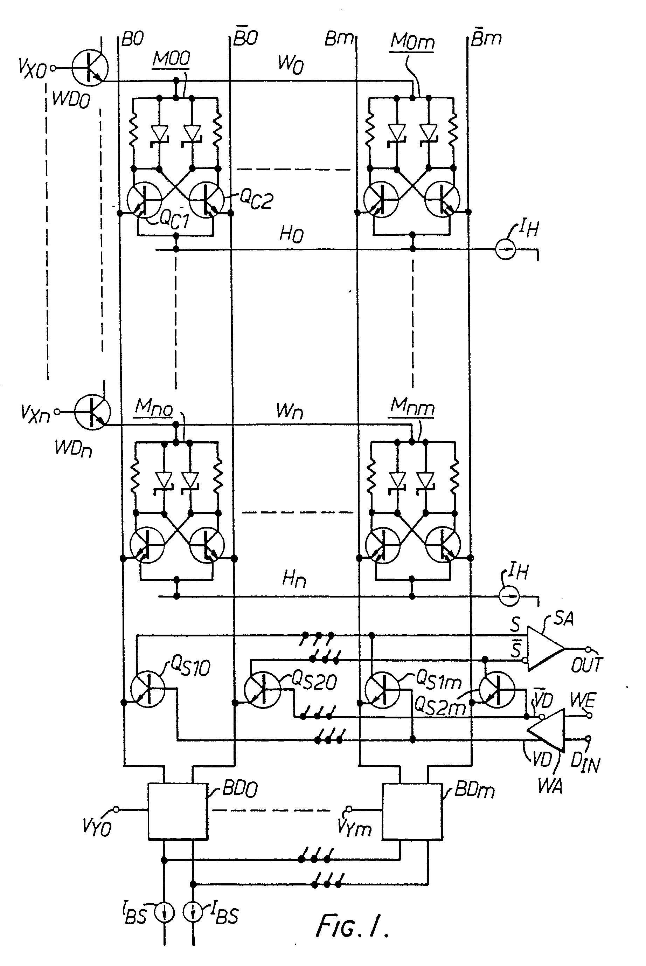

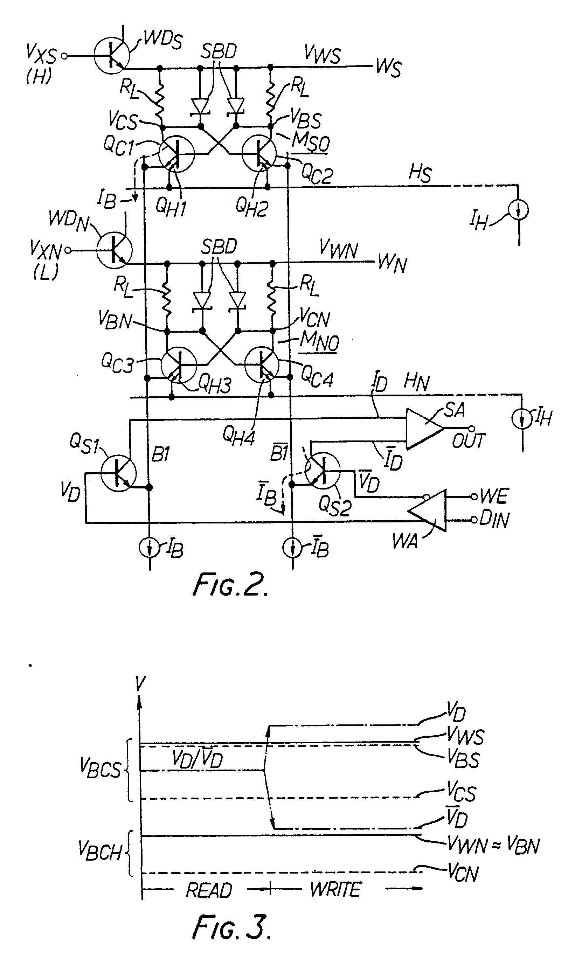

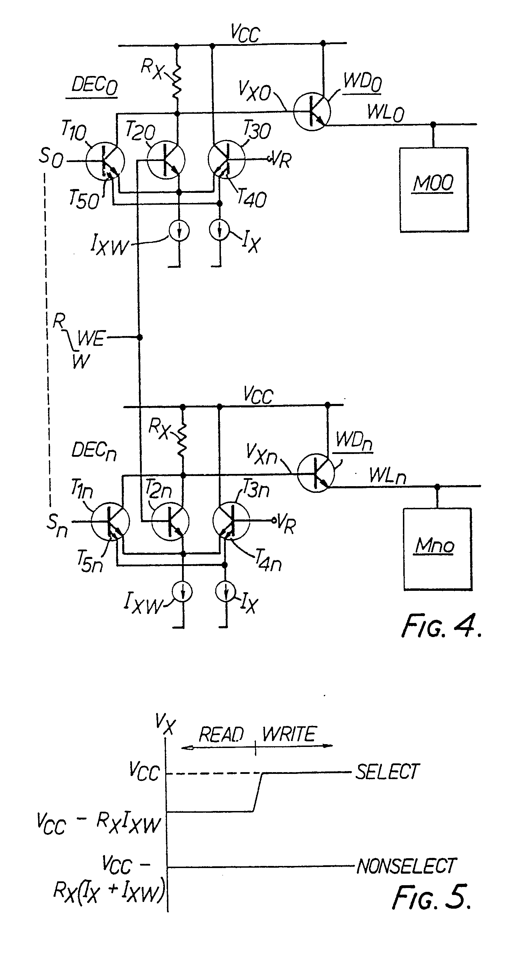

In such a memory cell array in which memory cells are arranged in the form of a matrix, a level difference is provided between the potentials of selected and non-selected word lines. This level difference has been determined from the point of view of the provision of a margin at a time when writing data into the memory cells and therefore the value of this level difference thus obtained has been excessive or inadequate at a time when data reading takes place. This is explained hereunder with reference to Figures 1 to 3 of the accompanying drawings, of which Figure 1 is a schematic diagram of a static type RAM, Figure 2 is a schematic diagram of a detail of the RAM of Figure 1, and Figure 3 is a voltage chart.

Figure 1 shows the general form of a memory cell array in which memory cells MOO . . . Mno, . . ., Mom . . . Mnm are arranged in the form of a (n+1)×(m+1) matrix. Each memory cell has, as indicated by way of example for cell MOO, a flip-flop circuit wherein the collectors and bases of a pair of bipolar transistors (Qc1, Qc2) are cross-connected, WO . . . Wn are word lines, HO . . . Hn are hold lines, and BO . . . Bm, $\overline{BO}$ . . . $\overline{Bm}$ are bit lines. Word lines WO . . . Wn are selected by means of word drivers WDO . . . WDn, whilst bit line pairs (BO, $\overline{BO}$) . . . (Bm, $\overline{Bm}$) are selected by bit drivers BDO . . . BDm. The bit drivers BDO to BDm form current switch circuits in combination with constant current sources IBS. A current is applied to only a single pair of bit lines in dependence upon Y selection signals $V_{YO}$ to $V_{Ym}$. Only one pair of bit lines is selected. It can also be provided that current is applied to all lines. A selection is made from amongst word drivers WDO to WDn in dependence upon X selection signals $V_{xo}$ to $V_{xn}$ so as to make one word line "H" (high) level and to make the remaining word lines "L" (low) level. SA is a sense amplifier which forms the detecting system for detecting the contents stored in a memory cell in combination with transistors ($Q_{S10}$, $Q_{S20}$) . . . ($Q_{S1m}$, $Q_{S2m}$) for the bit line pairs ((BO, $\overline{BO}$) . . . (Bm, $\overline{Bm}$)). The sense amplifier SA has an output OUT and the transistor pairs ($Q_{S10}$, $Q_{S20}$) to ($Q_{S1m}$, $Q_{S2m}$) are connected to input lines S, $\overline{S}$ of SA. WA is a write amplifier which generates an output VD≠$\overline{VD}$ in accordance with an input Din when a write signal WE is "L" level, namely at the time of writing, and which generates an output VD=$\overline{VD}$ when the write signal WE is "H" level, namely at the time of reading.

Constant current sources IH are provided on hold lines HO to Hn.

Explained hereunder are operations which occur when a pair of bit lines BO, $\overline{BO}$ is selected and moreover when a word line $W_S$ is selected (in relation to a selected line the subscript S is used, and in relation to a non-selected line the subscript N is used.).

Figure 2 shows in more detail a part of Figure 1, while the chart of Figure 3 shows potential relationships of terminals and circuit points indicated in Figure 2.

When X selection signal $V_{XS}$ becomes "H", the potential $V_{WS}$ of the word line $W_S$ of a selected memory cell $M_{SO}$ is kept high by word driver $WD_S$. At this time since the other X selection signals ($V_{XN}$) are "L", the potential ($V_{WN}$) of the remaining word lines $W_N$ is kept low by means of word drivers $WD_N$.

Read operation and write operation for the memory cell $M_{SO}$ under these conditions will be explained with reference to Figure 3.

The selected memory cell $M_{SO}$ (similar to non-selected cell $M_{NO}$) is an emitter detection type cell consisting of a couple of load resistances $R_L$, Schottky barrier diodes SBD and multi-emitter transistors. The transistors $Q_{H1}$ to $Q_{H4}$ on the side of hold lines $H_S$, $H_N$, of the multi-emitter transistors of cells $M_{SO}$, $M_{SN}$ are memory holding transistors, while transistors $Q_{C1}$ to $Q_{C4}$ on the side of bit lines B1, $\overline{B1}$ are driver transistors.

If transistor $Q_{H1}$ of memory cell $M_{SO}$ is ON, and $Q_{H2}$ is OFF, before selection, the relationship $V_{BS} > V_{CS}$ is obtained between the base voltage $V_{BS}$ of the transistor $Q_{c1}$ and collector voltage $V_{CS}$ of $Q_{c1}$ at the time of selection. Here, voltage difference ($V_{BS} - V_{CS}$) is taken to be $V_{BCS}$ (see Figure 3). The base voltage $V_{BS}$ is obtained by subtracting a voltage drop value (which is very small) expressed as the product of load resistance $R_L$ of $Q_{c2}$ and base current of $Q_{c1}$ from the word line voltage $V_{WS}$, whilst the collector voltage $V_{CS}$ is obtained by subtracting a value of the forward direction voltage drop ($V_{BE}$) of SBD from $V_{cc}$, because the collector current of $Q_{c1}$ is sufficiently high so that the diode SBD becomes ON. Thus, as shown in Figure 3, $V_{CS}$ is kept low.

Read operation under these conditions will be explained hereunder. First, the write amplifier WA generates outputs $V_D$, $\overline{V}_D$ which are in the following relationship,

$$V_{CS} < V_D = \overline{V}_D < V_{BS}.$$

Since transistors $Q_{c1}$ and $Q_{s1}$, $Q_{c2}$ and $Q_{s2}$ respectively form current switches, the transistors $Q_{c1}$ becomes ON, whilst $Q_{s1}$ becomes OFF and the current $I_B$ of bit line B1 is supplied from the transistor $Q_{c1}$. Simultaneously, since $V_{CS} < \overline{V}_D$ the transistor $Q_{s2}$ becomes ON, whilst $Q_{c2}$ becomes OFF. Thus current $\overline{I}_B$ of the bit line $\overline{B1}$ is supplied from the transistor $Q_{s2}$. For this reason, the currents viewed from the sense amplifier SA are as follows. $I_D=0$, $\overline{I}_D=\overline{I}_B$. The information of memory cell $M_{SO}$ can be read from the difference between these currents.

Now, a write operation will be explained. Here it is taken that the condition of memory cell $M_{SO}$ is to be inverted by the write operation. For this purpose, first of all, it is necessary to reduce $\overline{V}_D$ to below the collector voltage $V_{CS}$ (about 200 mV or more) in order to turn $Q_{c2}$ to OFF from ON. When $\overline{V}_D$ is brought down and becomes equal to $V_{CS}$ ($\overline{V}_D=V_{CS}$), the current $\overline{I}_B$ of the bit line $\overline{B1}$ flows equally into transistors $Q_{c2}$ and $Q_{s2}$, and moreover when $\overline{V}_D$ is brought further down ($\overline{V}_D<V_{CS}$), the current $\overline{I}_B$ flows, on the contrary, from the transistor $Q_{c2}$ and thereby the transistor $Q_{c2}$ becomes ON, while $Q_{s2}$ becomes OFF. As a result, $V_{BS}$ becomes low and the flip-flop of $M_{SO}$ is inverted (not indicated in Figure 3). When $V_{BS}<V_D$, even if said $V_D$ remains at a potential equal to that in read operation, the transistor $Q_{s1}$ becomes ON, whilst transistor $Q_{c1}$ becomes OFF. In such a conventional memory, the level of $V_D$ is generally boosted as indicated in Figure 3 in order to speed-up the write operation. Therefore, turning to OFF is performed more quickly.

Problems associated with the abovementioned write and read operations will be explained. At the time of write operation, the potential $V_{WN}$ of the non-selected word line $W_N$ must be such that

$$V_{WN}<\overline{V}_D(<V_{CS}).$$

If the transistor $Q_{H4}$ of the non-selected memory cell $M_{NO}$ is in ON state at the time of writing operation, the base voltage $V_{BN}$ is almost equal to $V_{WN}$. If the relationship $V_{WN}>\overline{V}_D$ is established while $\overline{V}_D$ is brought down for write operation, the transistor $Q_{c4}$ becomes ON and the current $\overline{I}_B$ of the bit line $\overline{B1}$ is supplied from the transistor $Q_{c4}$. Now, the transistor $Q_{c2}$ cannot turn sufficiently ON or it requires an excessively long period for $Q_{c2}$ to become ON. In order to avoid such a disadvantage, the relationship

$$V_{CS}>\overline{V}_D>V_{WN}\approx V_{BN}$$

must be satisfied.

On the other hand, the potential $V_{WN}$ of the non-selected word line must be lower than $V_{WS}$ by a constant value (in read operation) but it is not required to be as low as in write operation. Namely, it is sufficient for $V_{WN}$ to be a little lower than $V_D=\overline{V}_D$. In other words, if

$$V_{WN}=V_{BN}=V_D=\overline{V}_D$$

at the time of read operation, the current $\overline{I}_B$ of the bit line $\overline{B1}$ is supplied from both transistors $Q_{s2}$ and $Q_{c4}$. Thereby, a difference of currents $(\overline{I}_D-I_D)$ at the sense amplifier SA is reduced by half, and it becomes difficult to read the content of cell $M_{SO}$. Such a disadvantage can be avoided by reducing the potential $V_{WN}$ of the non-selected word line $W_N$ to a value less than the value $V_D=\overline{V}_D$.

However, since the word line potential of a non-selected cell, or the word line potential of a selected cell, is conventionally constant anytime during read and write operations, the difference between the selected word line voltage $V_{WS}$ and non-selected word line voltage $V_{WN}$ during read operation has been excessively high. This means that word line voltage rises drastically during changeover to a selected condition from a non-selected condition, namely during transition to a read operation. Since it is naturally necessary to charge the stray capacitance of word lines to provide for such a rise of word line voltage, a longer period is required for the rise of word line voltage to be accomplished. This problem brings about a disadvantage in that read operation speed is reduced.

Such a disadvantage can be eliminated by changing the level difference between the selected word line and non-selected word line for read and write operations. Moreover, the same effect can be obtained by changing the single selected word line level for read and write operations.

This example will be explained by reference to Figure 4 of the accompanying drawings which is a schematic circuit diagram. The circuit shown in Figure 4 includes decoders $DEC_0$ to $DEC_n$ and word drivers $WD_0$ to $WD_n$. In regard to decoders $DEC_0$ to $DEC_n$ only a part thereof is shown. In the decoders $DEC_0$ to $DEC_n$, transistors $(T_{10}, T_{20}, T_{30})$ to $(T_{1n}, T_{2n}, T_{3n})$ respectively form current switches, and transistors $(T_{40}, T_{50})$ to $(T_{4n}, T_{5n})$ respectively form current switches. One of decoder signals $S_0$ to $S_n$ becomes low (L) level ($S_0$ for example) and the transistors $(T_{10}, T_{50})$ become OFF. Thus, one of the selection signal voltages $V_{X0}$ to $V_{Xn}$ becomes high (H) level. Thereby, one of the word line $WL_0$ to $WL_n$ becomes H level, namely one word line is selected. At this time, all of the remaining signals among $S_0$ to $S_n$ become H level, making the relevant transistors $(T_{10}, T_{50})$ to $(T_{1n}, T_{5n})$ ON, and resultingly all of the remaining selection signal voltages among $V_{X0}$ to $V_{Xn}$ become L level, so that the relevant word lines become L level.

The level of a word line $WL_0$ to $WL_n$ is higher at a time at which the line is selected than it is at the time at which the line is non-selected. However, the selected level is higher during a write operation than it is during a read operation, as shown in Figure 5. In other words, write control signal WE becomes H during a read operation and becomes L during a write operation. During a read operation, at the current switches $T_{10}, T_{20}, T_{30}$ which relate to a selected word line, for example, $WL_0$, the transistor $T_{20}$ becomes ON. At the current switch consisting of the transistors $T_{40}, T_{50}$, the transistor $T_{40}$ becomes ON and a current of current source $I_X$ flows through said transistor $T_{40}$, but not through the load resistance $R_X$. On the other hand, when the transistor $T_{20}$ becomes ON, current $I_{XW}$ flows into the load resistance $R_X$. Therefore, the selection signal voltage $V_{X0}$ is reduced to $(V_{CC}-R_XI_{XW})$ as indicated in Figure 5. This voltage is higher than the level

$$(V_{CC}-R_X(I_X+I_{XW}))$$

which is the level of $V_{X0}$ in the non-selected condition, but is lower than the level $V_{CC}$.

Meanwhile, since $S_0=L$, $WE=L$ at the time of a write operation, the transistors $T_{30}$, $T_{40}$ are ON, whilst $T_{10}$, $T_{20}$, $T_{50}$ are OFF. Therefore, the currents $I_X$, $I_{XW}$ do not flow into the resistor $R_X$. Thereby, the selection signal voltage $V_{X0}$ becomes the highest power supply voltage $V_{CC}$.

At the time of non-selection, $S_0$ becomes H level (similar to the other non-selected word lines), the transistors $T_{10}$, $T_{50}$ become ON and the currents $I_X$, $I_{XW}$ flow into the resistance $R_X$. As a result, the selection signal voltage $V_{X0}$ becomes the lowest level in Figure 5.

By the above operations, the amplitude of the potential of a word line at the time of write operation can be made larger than that at the time of a read operation. However, the circuit shown in Figure 4 must provide current sources $I_X$, $I_{XW}$ for each of the decoders $DEC_0$ to $DEC_n$ which are provided for word drivers $WD_0$ to $WD_n$; therefore, the disadvantage of a large power consumption appears. Furthermore, multi-emitter type transistors are used, together with many other elements, in each of the decoders $DEC_0$ to $DEC_n$, and therefore, the structure required is complicated.

The circuit arrangement described above with reference to Figs. 4 and 5 is believed by the Applicant to form part of the state of the art in accordance with Article 54(2) EPC.

EP—A19 988, which forms part of the state of the art in accordance with Article 54(3) EPC, discloses a circuit arrangement for a bipolar RAM such that the potentials of non-selected word lines are lower in a read operation than in a write operation.

US—A—3 703 711 and US—A—3 541 531 disclose memory cell arrangements in which different voltages are applied to a word line of memory cell respectively for reading and writing the memory cell.

According to the present invention there is provided a memory device, having an array of memory cells with word lines connected to the memory cells, comprising:

word drivers for driving respective word lines of the device, operable to cause the potential of a selected word line to differ from that of a non-selected word line in dependence upon selection signals supplied to input terminals of the respective word drivers from respective word decoders, the word decoders being operable so that the potential of a selection signal supplied to the input terminal of a word driver of a selected word line differs from the potential of a selection signal supplied to the input terminal of a word driver of a non-selected word line, and

switching means connected to respective word drivers and so arranged as to cause the potential of a selection signal supplied to the input terminal of a word driver of a selected word line to differ from the potential of a selection signal supplied to the input terminal of a word driver of a non-selected word line by a greater amount in write operation than in read operation, whereby the potential difference between a selected and a non-selected word line is greater in a write operation than in a read operation,

the switching means comprising a plurality of switching parts connected to respective word drivers, and

each word driver comprising a driver transistor having a collector connected to a first power supply line, an emitter connected to a respective one of the word lines, and a base, acting as the input terminal of the word driver, connected to the first power supply line via a load, and connected to the corresponding respective one of the switching parts, characterised in that

each switching part comprises a rectifying circuit having first and second terminals, the first terminal connected to the base of the driver transistor of the respective word driver, and

in that the switching means further comprise a word line selection level switching circuit, connected in common to the second terminals of all the switching parts, and connected to a second power supply line, operable to switch between a condition, in a read operation, in which current flows from the switching part connected to the word driver of the selected word line, and hence from an input terminal of that word driver through the word line selection level switching circuit, and a condition, in a write operation, in which such current flow is prevented.

An embodiment of the present invention can provide a RAM device wherein the amplitude of the potential of a word line is changed for write and read operations, so that a high speed read operation and accurate write operation are ensured.

An embodiment of the present invention can provide a memory array driver circuit wherein non-selected word line voltage is of a constant value and selected word line voltage in write operation is higher than that in read operation.

An embodiment of the present invention can provide a driver circuit which uses a lesser number of elements, involves a simple circuit structure and provides for lesser power consumption.

Reference is made, by way of example, to the accompanying drawings, in which:—

Figure 1 is a schematic diagram indicating the general construction of a static type RAM,

Figure 2 is a more detailed schematic diagram of a part of a cell array of the RAM of Figure 1;

Figure 3 is a voltage chart for explanation of the relationship of voltages at terminals and circuit points in the circuit of Figure 2,

Figure 4 is a schematic circuit diagram of an example of a conventional memory cell array drive circuit,

Figure 5 is a voltage chart of operating waveforms, indicating potential relationships at terminals and circuit points in the circuit of Figure 4,

Figure 6 is a schematic diagram indicating the general construction of an embodiment of the present invention,

Figure 7 shows a voltage chart of operating waveforms, indicating potential relationships of terminals and circuit points in the circuit of Figure 6,

Figure 8 is a schematic circuit diagram of an embodiment of the present invention,

Figures 9A to 9C are schematic circuit diagrams of switching parts as employed in embodiments of the present invention,

Figure 10 is a schematic circuit diagram of another embodiment of the present invention,

Figure 11 is a schematic diagram of a further embodiment of the present invention,

Figure 12 is a schematic diagram of still another embodiment of the present invention, and

Figure 13 is a schematic circuit diagram of yet a further embodiment·of the present invention.

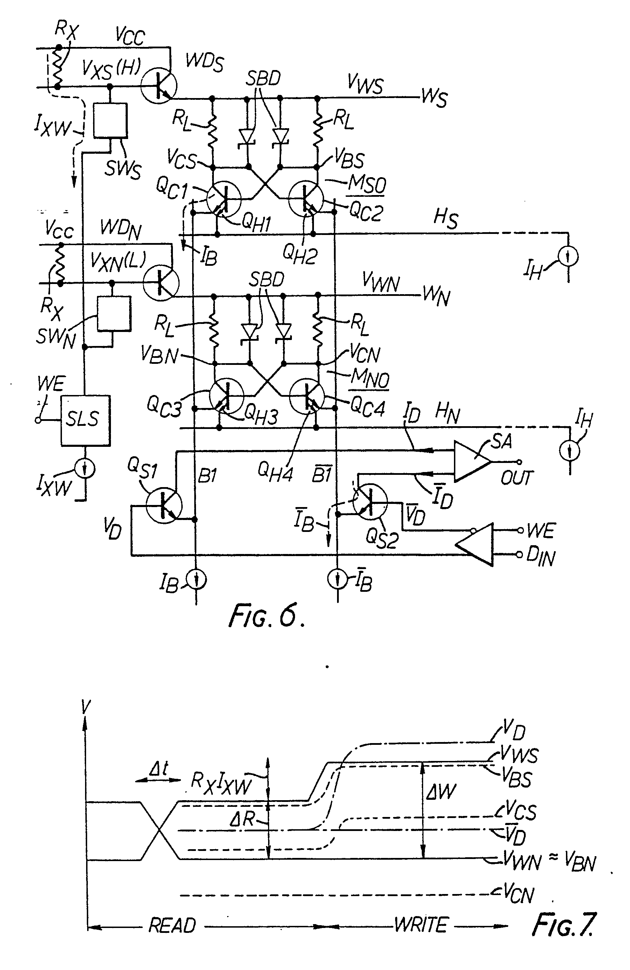

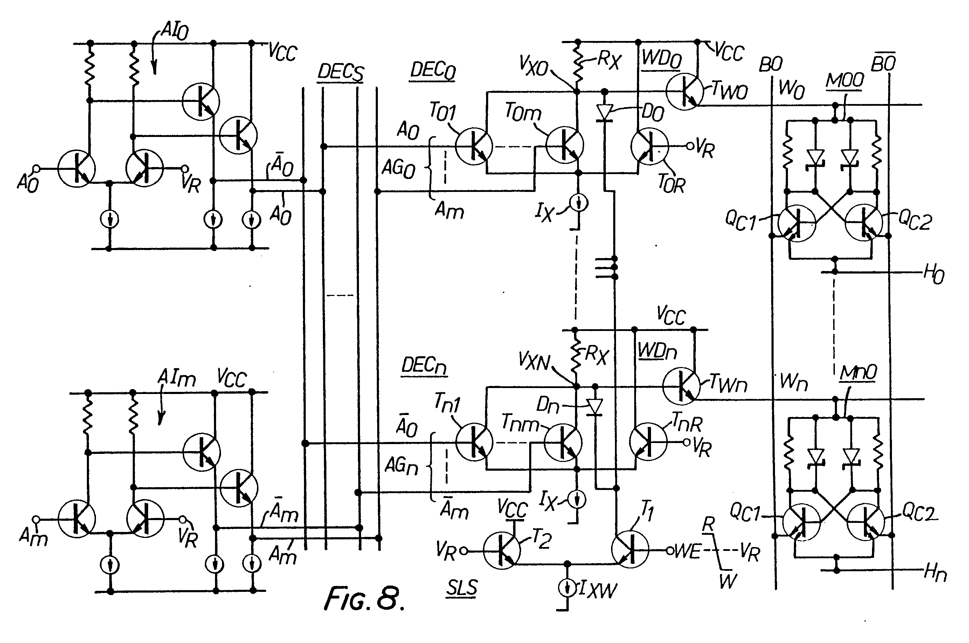

Figure 6 is a schematic circuit diagram for explanation in general terms of an embodiment of the present invention. The explanation of the operation of the circuit of Figure 6 is assisted by references to the waveforms of Figure 7.

Each item in Figure 6 corresponding to an item in Figure 2 is designated by the same reference symbol.

The conditions of information held by selected memory cell $M_{S0}$ and non-selected memory cell $M_{N0}$ are the same in Figure 6 as in Figure 2.

According to Figure 6, word drivers $WD_S$ to $WD_N$ provided in correspondence to word lines $W_S$ to $W_N$ are connected in such a way that a collector of a word driver is connected to a higher voltage power supply $V_{cc}$, an emitter of a word driver is connected to a word line ($W_S$ to $W_N$) and a base is connected to an input terminal. To the bases of the word drivers selection signals $V_{XS}$ to $V_{XN}$ are supplied from decoders (not illustrated). Therefore, a high voltage selection signal $V_{XS}$ (H) is supplied to the base of the selected word driver $WD_S$, and the word line $W_S$ has thus a high voltage $V_{WS}$. To the base of another non-selected word driver $WD_N$, a low voltage selection signal $V_{XN}$ (L) is supplied and thereby the word line $W_N$ is kept at a low voltage $V_{WN}$.

Moreover, according to Figure 6, word line selection level switching circuit SLS is provided in common to the base points of the input terminals of the word drivers $WD_S$ to $WD_N$ via switching parts $SW_S$ to $SW_N$, respectively. The word line selection level switching circuit SLS passes a current $I_{xw}$ from the input terminal of the selected word driver $WD_S$ in read operation, in accordance with write control signal WE. Namely, the current $I_{xw}$ flows through the route:— power supply $V_{cc}$—load resistance $R_X$—switching part; $SW_S$—switching circuit SLS. In particular, rectifying elements can be used as the switching parts $SW_S$ to $SW_N$ so that the current $I_{xw}$ is applied from only that selected word driver $WD_S$ which has the highest voltage of the input terminals (bases) of the word drivers $WD_S$ to $WD_N$. When a current $I_{xw}$ flows, in a read operation, read oper-

ation selection signal $V_{XS}$ is reduced by $R_X I_{xw}$ as compared with that in a write operation. In other words, amplitude $\Delta R$ of the difference in potentials of selected and non-selected word lines in a read operation is smaller than the amplitude $\Delta W$ of the difference in the potentials of selected and non-selected word lines in a write operation. $\Delta R$ is smaller than $\Delta W$ by $R_X I_{xw}$. Thus, the amplitude $\Delta R$ in a read operation is set to a minimum value, the switching time of a selected word line in a read operation becomes short as compared with a conventional time as indicated by $\Delta t$ of Figure 7. This means that the access time of the RAM is reduced.

The structure shown in Figure 6 is simpler and consumes less power for several reasons. First, the voltage level of only the one selected word line amongst the plurality of word lines is changed; second, a common current source $I_{xw}$ is provided and thereby current $I_{xw}$ is supplied to only one selected word line.

Figure 8 is a schematic diagram indicating an embodiment of the present invention as adopted to a logical decoder.

The decoder $DEC_S$ generates signals $A_0$ to $A_m$ and inverted signals $\overline{A}_0$ to $\overline{A}_m$ from address inputs $A_0$ to $A_m$, using address inverters $AI_0$ to $AI_m$ of current switch structure. The 2m bit made up of $A_0$ to $A_m$ and $\overline{A}_0$ to $\overline{A}_m$ can be combined as desired in up to n+1 ($n+1=2^{m+1}$) m-bit pairs from ($A_0$, $A_1$, ..., $A_m$) to ($\overline{A}_0$, $\overline{A}_1$, ..., $\overline{A}_m$).

n+1 decoders $DEC_0$ to $DEC_n$ are provided and address signal groups $AG_0$ to $AG_n$ are provided for the decoders $DEC_0$ to $DEC_n$ respectively. Decoder $DEC_0$ provides a NOR gate composed of transistors $T_{01}$ to $T_{0m}$, receiving as inputs $A_0$ to $A_m$, load resistance $R_X$, transistor $T_{OR}$ which forms a current switch together with the NOR gate and a constant current source. Selection signal voltage $V_{XO}$ obtained from the decoder $DEC_0$ is applied to an input terminal (base) of a word driver $WD_0$ (comprising transistor $T_{WO}$). Further word drivers ($WD_1$ to $WD_n$) and decoders are also structured in the same way. Operations are performed as well known. When all of $A_0$ to $A_m$ become L level, the transistors $T_{01}$ to $T_{0m}$ become OFF. As a result, $V_x$ ($V_{XO}$) becomes equal to $V_{cc}$ and word line $W_0$ has a selection level. On the contrary, when any one of $A_0$ to $A_m$ is H, current $I_x$ flows into load resistance $R_X$, $V_x$ ($V_{XO}$) becomes equal to $V_{cc}-R_X I_x$ and the word line $W_0$ has a non-selection level.

In this embodiment, diodes $D_0$ to $D_n$ are provided as rectifying elements of switching parts in order to change the amplitude of the potential of the word lines in read and write operations, and moreover a single word line selection level switching circuit SLS consisting of transistors $T_1$ and $T_2$, and a constant current source $I_{xw}$ is provided in common to the decoders $DEC_0$ to $DEC_n$. The first and second transistors $T_1$, $T_2$ are emitter-connected and the common emitter side is connected to the current source $I_{xw}$. A reference voltage $V_R$ is applied to the base of the second transistor $T_2$ and its collector is connected to a suitable voltage ($V_{cc}$, for example). On the other hand, write control signal WE is applied to the base of the first transistor and its collector is connected in common to the cathodes of diodes $D_0$ to $D_n$. The anodes of diodes $D_0$ to $D_n$ are connected to the points $V_X$ ($V_{XO}$ to $V_{XN}$) of the word drivers $WD_0$ to $WD_n$ respectively (in Figure 8, $V_X$ is as $V_{XS}$ when at a selected level, and as $V_{XN}$ when at a non-selected level).

The operation of decoders and word drivers thus structured is explained below.

When the word line $W_0$ is selected, all signals $A_0$ to $A_m$ of the address signal group $AG_0$ become L level, while at least one bit of each other address signal group (represented by $AG_n$) becomes H level. Therefore, at decoder $DEC_n$ and word driver $WD_n$, at least one of transistors $T_{n1}$ to $T_{nm}$ becomes ON and the current $I_X$ flows through the load resistance $R_X$. Thereby, the potential of the selection signal $V_{XN}$ becomes equal to ($V_{cc}$—$R_XI_X$). As a result, the non-selected word line $W_n$ is kept at the lowest non-selection level. On the other hand, at the decoder $DEC_0$ and word driver $WD_0$, all of the transistors $T_{01}$ to $T_{0m}$ become OFF. Therefore, the level of $V_{XO}$ is determined by a factor other than $I_X$. The write control signal WE is H in a read operation, transistor $T_1$ becomes ON. As a result, current $I_{XW}$ flows on the route:—

$$V_{cc}—R_X—V_{XO}—D_0—T_1,$$

and $V_{XS}$ (selected level of $V_{XO}$) becomes equal to ($V_{cc}$—$R_XI_{XW}$) (intermediate value). Since the rectifying elements, diodes $D_0$ to $D_n$ form current switch, $I_{XW}$ flows from the highest point of $V_{XO}$ to $V_{XN}$. Therefore, when $I_X > I_{XW}$, $V_{XS}$ is larger than $V_{XN}$ ($V_{XS} > V_{XN}$). Thus, $I_{XW}$ flows only into load resistance $R_X$ (of the selected decoder $DEC_0$).

In the write operation mode (W), WE=L. Therefore, the transistor $T_1$ becomes OFF and the current $I_{XW}$ flows in the side of transistor $T_2$. Namely, the current $I_{XW}$ does not flow into any load resistance $R_X$. For this reason, neither $I_X$ nor $I_{XW}$ flows into the word driver $WD_0$ and resultingly $V_{XS}$ becomes equal to $V_{cc}$ (maximum value).

Variation of the potential amplitude of the word lines thus obtained shows a characteristic similar to that obtained conventionally in Figure 5. However, in this embodiment of the present invention a current switch is formed with rectifying element, diodes $D_0$ to $D_n$ and the word line selection level switching circuit SLS comprising current source $I_{XW}$ and transistors $T_1$, $T_2$ is used in common for all word drivers, thus drastically simplifying circuit structure as compared with the conventional circuit shown in Figure 4 and providing high density integration. Moreover, this embodiment of the invention does not use multi-emitter type transistors and therefore has a simplified circuit pattern and uses fewer current sources, thus consuming less electrical power.

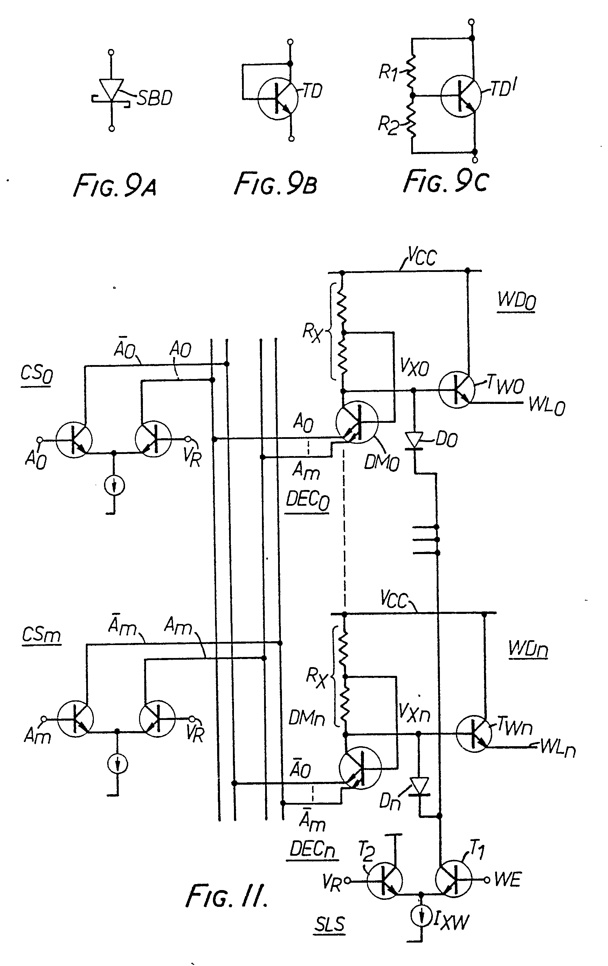

In the embodiment of Figure 8, as the rectifying element of the switching parts, diodes $D_0$ to $D_n$ are used. However, any suitable rectifying element can be used. For example, a Schottky barrier diode SBD as shown in Figure 9A, a transistor TD with base and collector connected as shown in Figure 9B, or a rectifying circuit consisting of resistances $R_1$, $R_2$ and transistor TD' as shown in Figure 9C can also be used.

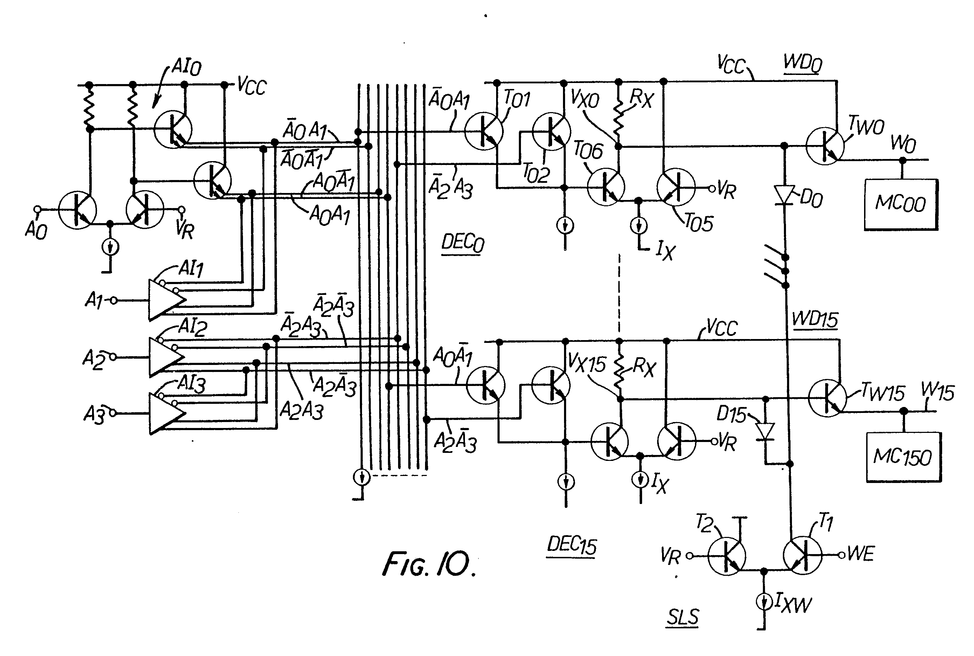

Figure 10 is a schematic diagram illustrating another embodiment of the present invention. In Figure 10, the present invention is adopted to a logical decoder of a type different from that of Figure 8.

The operation of this type of logical decoder is as follows.

First, eight 2-bit combinations $\bar{A}_0A_1$, $\bar{A}_0\bar{A}_1$, to $A_2\bar{A}_3$ are generated by combining non-inverted and inverted outputs of address inverters $AI_0$ to $AI_3$ which receive inputs $A_0$ to $A_3$. $\bar{A}_0A_1$ becomes L level when both $\bar{A}_0$ and $A_1$ are L but becomes H level when any one is H. This is also true of $\bar{A}_0A_1$ to $A_2\bar{A}_3$. Respective pairs of these 2-bit combinations are used as inputs of decoders $DEC_0$ to $DEC_{15}$. Decoder $DEC_0$, to which the other decoders are similar, is composed of transistors $T_{01}$, $T_{02}$ which are controlled by the inputs $\bar{A}_0A_1$, $\bar{A}_2A_3$, load resistance $R_X$, transistors $T_{05}$, $T_{06}$ forming a current switch, and a current source $I_X$. Word driver $WD_0$ is composed of a transistor $T_{wo}$. Operation is the same as in the embodiment of Figure 8. When both $\bar{A}_0A_1$ and $\bar{A}_2A_3$ are L level and transistors $T_{01}$, $T_{02}$ become OFF, the transistor $T_{06}$ becomes OFF, resulting in $V_X$ ($V_{XO}$)=$V_{cc}$. Thus, the word line $W_0$ has a selection level. Meanwhile, when at least one of $\bar{A}_0A_1$, $\bar{A}_2A_3$ is H level, the transistor $T_{06}$ becomes ON, resulting in

$$V_X(V_{XO})=V_{cc}—R_XI_X.$$

Thus, the word line $W_0$ has a non-selection level.

As in the case of Figure 8, in the embodiment of Figure 10, diodes $D_0$ to $D_{15}$ are provided as switching parts at input terminals $V_{XO}$ to $V_{X15}$ (here selection signals are applied) of the transistors $T_{wo}$ to $T_{w15}$ of the word drivers $WD_0$ to $WD_{15}$ and these diodes are connected in common to a single word line selection level switching circuits SLS. The operation is the same as Figure 8 and therefore explanation is omitted here.

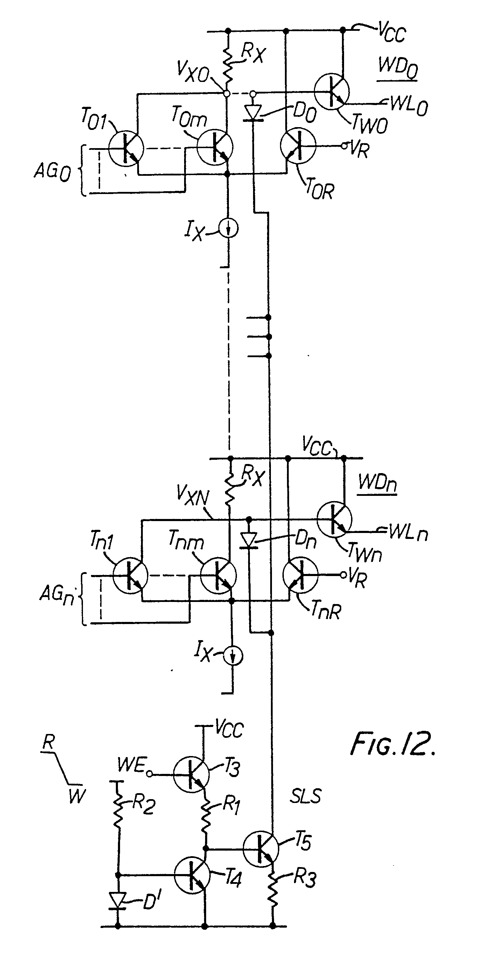

Figure 11 shows a further embodiment of the present invention employing a generate diode matrix type decoder. This decoder has current switches $CS_0$ to $CS_m$ in each of which one transistor receives one of address signals $A_0$, $A_1$ ..., while another transistor receives a reference voltage $V_R$. Thereby, signals $A_0$ to $A_m$ are inverted signals $\bar{A}_0$ to $\bar{A}_m$ can be obtained. Thereafter, desired selections of $m+1$ signals among the $2(m+1)$ signals $A_0$ to $\bar{A}_m$ are connected to the $m+1$ emitters of respective multi-emitter transistors of diode matrixes $DM_0$ to $DM_N$ of decoders $DEC_0$ to $DEC_n$. In the selected diode matrix from amongst the diode matrixes $DM_0$ to $DM_n$, all emitters are at the H level and the multi-emitter transistor becomes OFF. Thereby, the selected one of the input terminals $V_{XO}$ to $V_{Xn}$ of the word drivers $WD_0$ to $WD_n$ becomes H level and the relevant word line $WL_0$ to $WL_n$ is set to a high potential selection level. When any one of the

transistors in $DM_0$ and $DM_n$ becomes ON, a voltage drop occurs across resistance $R_X$ and the selection signal ($V_{X0}$ to $V_{Xn}$) becomes L level. As a result, corresponding word line is set to the low potential non-selection level.

In the embodiment, diodes $D_0$ to $D_n$ are provided as switching parts connected to input terminals (to which selection signals $V_{X0}$ to $V_{Xn}$ are applied) of driver transistors $T_{w0}$ to $T_{wn}$ of word drivers $WD_0$ to $WD_n$ as in the case of Figure 8, and these diodes are connected in common to one word line selection level switching circuit SLS. The operation is the same as that of Figure 8 and therefore explanation is omitted here.

In the above embodiment, the word line selection level switching circuit SLS is configurated by a current switch consisting of the transistors $T_1$, $T_2$ and a constant current source $I_{XW}$, but other circuit configurations can be used.

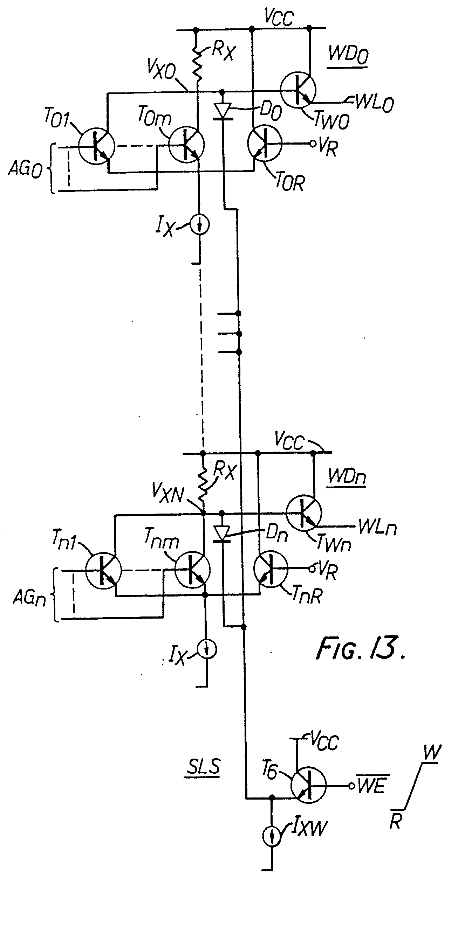

Figure 12 shows still another embodiment of the present invention adopted to a logical decoder of the kind seen in Figure 8. In Figure 12 the word line selection level switching circuit SLS has switching parts comprising diodes $D_0$ to $D_n$, transistors $T_3$, $T_4$, $T_5$, resistors $R_1$, $R_2$ and $R_3$, and diode $D'$. Respective elements are connected as indicated in Figure 12. The collector of transistor $T_3$, and resistor $R_2$, are connected to a suitable voltage ($V_{cc}$ for example), whilst the diode $D'$, the emitter of transistor $T_4$ and resistor $R_5$ are connected to a low voltage. The base of transistor $T_3$ is connected to receive a write control signal WE.

With such a structure, since the write control signal WE becomes H level in read operation (R), the transistor $T_3$ becomes ON and the transistor $T_5$ also becomes ON. Thereby, a current flows through the route,

$$V_{cc}—R_X—V_{XS} \text{ (e.g., } V_{X0})—D_0—T_5—R_3,$$

setting $V_{XS}$ ($V_{X0}$) to an intermediate value. On the other hand, in write operation (W), signal WE becomes L level and therefore the transistors $T_3$, $T_5$ becomes OFF. Thus no signal flows into any of the diodes $D_0$ to $D_n$, setting $V_{XS}$ (e.g. $V_{X0}$) to $V_{cc}$ (maximum value). Of course, this embodiment can be adopted to a decoder of the diode matrix type.

Figure 13 is a still further embodiment of the present invention, being adopted to a logical decoder. In this embodiment, switching parts comprising diodes $D_0$ to $D_n$ and word line selection level switching circuit SLS consisting of transistor $T_6$ and constant current source $I_{xw}$ are provided. Connections are as indicated in the Figure. The base of transistor $T_6$ is connected to receive an inverted write control signal WE, namely $\overline{WE}$. During a read operation (R), $\overline{WE}$ is L level and the transistor $T_6$ turns OFF and thereby the current $I_{xw}$ flows from the highest voltage of the selection signal voltages $V_{X0}$ to $V_{XN}$. Meanwhile, during write operation (W), $\overline{WE}$ achieves a sufficiently high level and current $I_{xw}$ flows into the transistor $T_6$ in the ON state. Of course, this embodiment can also be adopted to the diode matrix type decoder.

As explained previously, an embodiment of the present invention can provide a circuit which changes the amplitude of the potential of a word line for write and read operations, and particularly provides a driver circuit of a memory cell array of a simple circuit structure, which facilitates realization of high speed read and accurate write operation by making the selected word line potential higher during write operation than during read operation, while the potential of non-selected word lines is kept at a constant value. Therefore, a reduction in the number of elements required makes possible higher integration density or pattern simplification and, moreover, reduction in current sources brings about less power consumption. This represents real advantage.

A random access memory device embodying the present invention has a memory cell matrix array comprising a plurality of memory cells each having a flip-flop circuit wherein a pair of transistors are cross-connected and has word driver transistors provided in correspondence to a plurality of word lines of the memory device. Each word driver transistor has its collector connected to a high power supply voltage and its emitter connected to a word line. Moreover, the bases of the word driver transistors are connected in common to a word line selection level switching circuit via respective diodes. The word line selection level switching circuit supplies a current in write operation to the common connecting point of diodes and forms a current switch together with the diodes. The voltage of a selected word line in write operation is lower than that in read operation. An embodiment of the present invention can offer a random access memory device which has a simplified structure, consumes less current and assures high speed read operation.

## Claims

1. A memory device, having an array of memory cells ($M_{S0}$, $M_{N0}$; $M_{00}$, $N_{n0}$; $MC_{00}$, $MC_{150}$) with word lines ($W_S$, $W_N$; $W_0$, $W_n$; $WL_0$, $WL_n$; $W_0$, $W_{15}$) connected to the memory cells, comprising:
word drivers ($WD_S$, $WD_N$; $WD_0$, $WD_n$; $WD_0$, $WD_{15}$) for driving respective word lines of the device, operable to cause the potential ($V_{WS}$) of a selected word line to differ from that ($V_{WN}$) of a non-selected word line in dependence upon selection signals supplied to input terminals of the respective word drivers from respective word decoders ($DEC_0$, $DEC_n$; $DEC_0$, $DEC_{15}$), the word decoders being operable so that the potential of a selection signal ($V_{XS}$; $V_{X0}$, $V_{Xn}$; $V_{X0}$, $V_{X15}$) supplied to the input terminal of a word driver of a selected word line differs from the potential of a selection signal ($V_{XN}$; $V_{X0}$, $V_{Xn}$; $V_{X0}$, $V_{X15}$) supplied to the input terminal of a word driver of a non-selected word line, and
switching means ($SW_S$, $SW_N$, SLS; $D_0$, $D_n$, SLS; $D_0$, $D_{15}$, SLS) connected to respective word drivers ($WD_S$, $WD_N$; $WD_0$, $WD_n$; $WD_0$, $WD_{15}$) and so arranged as to cause the potential of a selection signal ($V_{XS}$) supplied to the input terminal of a word driver of a selected word line to differ from the potential of a selection signal ($V_{XN}$) supplied to the input terminal of a word driver of a non-selected word line by a greater amount in write operation than in read operation, whereby the potential difference between a selected and a non-selected word line is greater in a write operation than in a read operation,

the switching means comprising a plurality of switching parts ($SW_S$, $SW_N$; $D_0$, $D_n$; $D_0$, $D_5$) connected to respective word drivers, and

each word driver comprising a driver transistor ($T_{W0}$, $T_{wn}$, $T_{W0}$, $T_{W15}$) having a collector connected to a first power supply line ($V_{CC}$), an emitter connected to a respective one of the word lines, and a base, acting as the input terminal of the word driver, connected to the first power supply line via a load ($R_X$), and connected to the corresponding respective one of the switching parts, characterised in that

each switching part comprises a rectifying circuit ($D_0$, $D_n$; $D_0$, $D_{15}$; SBD; TD; TD', $R_1$, $R_2$) having first and second terminals, the first terminal connected to the base of the driver transistor of the respective word driver,

and in that the switching means further comprise a word line selection level switching circuit (SLS), connected in common to the second terminals of all the switching parts, and connected to a second power supply line, operable to switch between a condition, in a read operation, in which current flows from the switching part connected to the word driver of the selected word line, and hence from an input terminal of that word driver through the word line selection level switching circuit, and a condition, in a write operation, in which such current flow is prevented.

2. A device as claimed in claim 1, wherein the word line selection level switching circuit (SLS) has a current source ($I_{XW}$), such that in a read operation the rectifying circuits ($D_0$, $D_n$; $D_0$, $D_{15}$; SBD; TD; TD', $R_1$, $R_2$) and the current source form a current switch.

3. A device as claimed in claim 2, operable so that, in a read operation, the current source ($I_{XW}$) is connected to the rectifying circuits ($D_0$, $D_n$; $D_0$, $D_{15}$; TD; TD', $R_1$, $R_2$).

4. A device as claimed in claim 1, 2 or 3, wherein each switching part comprises a diode ($D_0$, $D_n$; $D_0$, $D_{15}$), a first terminal of which is connected to the input terminal of a respective word driver ($WD_0$, $WD_n$; $WD_0$, $WD_{15}$) and a second terminal of which is connected to the word line selection level switching circuit (SLS), in common with the second terminals of all the other switching parts.

5. A device as claimed in claim 1, 2 or 3, wherein each switching part comprises a Schottky barrier diode (SBD), a first terminal of which is connected to the input terminal of a respective word driver and a second terminal of which is connected to the word line selection level switching circuit (SLS), in common with the second terminals of all the other switching parts.

6. A device as claimed in claim 1, 2 or 3, wherein each switching part comprises a transistor (TD) with a base and a collector interconnected, and with the collector connected to the input terminal of a respective word driver, and with an emitter connected to the word line selection level switching circuit (SLS), in common with the emitters of all the other switching parts.

7. A device as claimed in claim 1, 2 or 3, wherein each switching part comprises a transistor (TD) with resistors ($R_1$, $R_2$) connected respectively between a base and a collector thereof and between the base and an emitter thereof, with the collector connected to the input terminal of a respective word driver, and with the emitter connected to the word line selection level switching circuit (SLS), in common with the emitters of all the other switching parts.

8. A device as claimed in any of claims 2 to 7, wherein the word line selection level switching circuit (SLS) comprises a first transitor ($T_2$) having a collector connected to a first power supply line ($V_{CC}$), an emitter connected to an emitter of a second transistor ($T_1$) and to the current source ($I_{XW}$), which current source is connected between the emitters of the first and second transistors ($T_1$, $T_2$) and a second power supply line, and a base connected for receiving a reference voltgage ($V_R$), a collector of the second transistor ($T_2$) being connected in common to the rectifying circuits ($D_0$, $D_n$; $D_0$, $D_{15}$; SBD; TD; TD'; $R_1$, $R_2$) and a base of the second transistor ($T_1$) being connected to receive a control signal (WE) which is higher than the reference voltage ($V_R$) in a read operation and lower than the reference voltage ($V_R$) in a write operation.

9. A device as claimed in any one of claims 2 to 7, wherein the word line selection level switching circuit (SLS) comprises a transistor ($T_6$) having a collector connected to a first power supply line ($V_{CC}$), an emitter connected in common to the current source ($I_{XW}$), which current source is connected between the emitter and a second power supply line, and to the rectifying circuits ($D_0$, $D_n$), and a base connected to receive a control signal ($\overline{WG}$) which is relatively high in a write operation and relatively low in a read operation.

10. A device as claimed in any one of claims 2 to 7, wherein the current provided by the current source ($I_{XW}$) flows in the load ($R_X$) of a selected word driver in a read operation, whilst a current ($I_X$) larger than the current provided by the current source ($I_{XW}$) flows in the load ($R_X$) of a non-selected word driver.

11. A device as claimed in claim 1, or any one of claims 4 to 7 read as appended to claim 1, wherein the word line selection level switching circuit (SLS) comprises a first transistor ($T_3$) having a collector connected to a first power supply line ($V_{CC}$), an emitter connected via a first resistor ($R_1$) to a collector of a second transistor ($T_4$) and to a base of a third transistor ($T_5$), a second resistor ($R_2$) connected between the first power supply line ($V_{CC}$) and a base of the second transistor ($T_4$), and a diode (D') connected between the base of the second transistor ($T_4$) and a second power supply line, the emitter of the second transistor ($T_4$) being connected to the second power supply line, the emitter of the third transistor (T₅) being connected to the second power supply line via a third resistor (R₃), the collector of the third transistor (T₅) being connected in common to the switching parts, and the base of the first transistor (T₃) being connected to receive a control signal (WE) which is relatively high in a read operation and relatively low in a write operation.

**Patentansprüche**

1. Speichervorrichtung mit einem Array von Speicherzellen ($M_{SO}$, $M_{NO}$; $M_{OO}$, $M_{no}$; $MC_{OO}$, $MC_{150}$), mit Wortleitungen ($W_S$, $W_N$; $W_O$, $W_n$; $WL_O$, $WL_n$, $W_O$, $W_{15}$), die mit den Speicherzellen verbunden sind, mit:

Worttreibern ($WD_S$, $WD_N$, $WD_O$, $WD_n$, $WD_O$, $WD_{15}$) zum Treiben entsprechender Wortleitungen der Vorrichtung, die betreibbar sind, um zu bewirken, daß das Potential ($V_{WS}$) einer ausgewählten Wortleitung von demjenigen ($V_{WN}$) einer nicht ausgewählten Wortleitung in Abhängigkeit von einem Selektionssignal unterschiedlich ist, welches den Eingangsanschlüssen der jeweiligen Worttreiber von entsprechenden Wortdecodern ($DEC_O$, $DEC_n$; $DEC_O$, $DEC_{15}$) zugeführt wird, welche Wortdecoder so betreibbar sind, daß das Potential des Auswahlsignals ($V_{XS}$, $V_{XO}$, $V_{Xn}$; $V_{XO}$, $V_{X15}$), welches dem Eingangsanschluß eines Wortreibers einer ausgewählten Wortleitung zugeführt wird, sich von dem Potential eines Auswahlsignals ($V_{XN}$; $V_{XO}$, $V_{Xn}$; $V_{XO}$, $V_{X15}$), welches dem Eingangsanschluß eines Worttreibers von einer nicht ausgewählten Leitung zugeführt wird, unterscheidet, und

Schalteinrichtungen ($SW_S$, $SW_N$, SLS; $D_O$, $D_n$, SLS; $D_O$, $D_{15}$, SLS), die mit den entsprechenden Worttreibern ($WD_S$, $WD_N$; $WD_O$, $WD_n$, $WD_O$, $WD_{15}$) verbunden und so angeordnet sind, daß sie bewirken, daß das Potential eines ausgewählten Signals ($V_{XS}$), welches dem Eingangsanschluß eines Worttreibers einer ausgewählten Wortleitung zugeführt wird, sich von dem Potential eines Auwahlsignals ($V_{XN}$), welches dem Eingangsanschluß eines Worttreibers einer nicht ausgewählten Wortleitung zugeführt wird, beim Schreibbetrieb um einen größeren Betrag als beim Lesebetrieb unterscheidet, wodurch die Potentialdifferenz zwischen einer ausgewählten und einer nicht ausgewählten Wortleitung beim Schreibbetrieb größer als beim Lesebetrieb ist,

die Schalteinrichtungen eine Vielzahl von Schaltteilen ($SW_S$, $SW_N$, $D_O$, $D_n$; $D_O$, $D_5$) umfaßt, die mit jeweiligen Worttreibern verbunden sind, und

jeder Worttreiber einen Treibertransistor ($T_{WO}$, $T_{Wn}$; $T_{WO}$, $T_{W15}$) umfaßt, der einen Kollektor hat, welcher mit einer ersten Energieversorgungsleitung ($V_{CC}$) verbunden ist, einen Emitter, der mit einer entsprechenden Wortleitung verbunden ist, und eine Basis, die als Eingangsanschluß für den Worttreiber wirkt und mit der ersten Energieversorgungsleitung über eine Last ($R_x$) verbunden ist und mit einem entsprechenden der Schaltteile verbunden ist, dadurch gekennzeichnet, daß

jedes Schaltteil eine Gleichrichterschaltung ($D_O$, $D_n$, $D_O$, $D_{15}$, SBD; TD; TD', $R_1$, $R_2$) umfaßt, welche erste und zweite Anschlüsse hat, der erste Anschluß mit der Basis des Treibertransistors des jeweiligen Worttreibers verbunden ist,

und daß die Schalteinrichtung ferner einen Wortleitungsauswahlpegel-Schaltkreis (SLS) umfaßt, der gemeinsam mit den zweiten Anschlüssen von allen Schaltteilen verbunden ist und mit einer zweiten Energieversorgungsleitung verbunden ist, die betreibbar ist, um zwischen einem Zustand zu schalten, in einem Lesebetrieb, bei welchem Strom von dem Schaltungsteil fließt, das mit dem Worttreiber der ausgewählten Wortleitung verbunden ist, und von dort von einem Eingangsanschluß von demjenigen Worttreiber über den Wortleitungsselektionspegel-Schaltkreis, und einem Zustand, in einem Schreibbetrieb, in dem ein solcher Stromfluß verhindert wird.

2. Vorrichtung nach Anspruch 1, bei der der Wortleitungsselektionspegel-Schaltkreis (SLS) eine Stromquelle ($I_{XW}$) hat, so daß in einem Lesebetrieb die gleichrichtenden Schaltungen ($D_O$, $D_n$; $D_O$, $D_{15}$; SBD; TD; TD', $R_1$, $R_2$) und die Stromquelle einen Stromschalter bilden.

3. Vorrichtung nach Anspruch 2, die so betreibbar ist, daß in einem Lesebetrieb die Stromquelle ($I_{XW}$) mit den gleichrichtenden Schaltungen ($D_O$, $D_n$; $D_O$, $D_{15}$; TD; TD', $R_1$, $R_2$) verbunden sind.

4. Vorrichtung nach Anspruch 1, 2 oder 3, bei der jedes Schaltteil eine Diode ($D_O$, $D_n$, $D_O$, $D_{15}$) umfaßt, von der ein erster Anschluß mit dem Eingangsanschluß eines entsprechenden Worttreibers ($WD_O$, $WD_n$; $WD_O$, $WD_{15}$) und ein zweiter Anschluß mit dem Wortleitungs-selektionspegel-Schaltkreis (SLS) verbunden ist, gemeinsam mit den zweiten Anschlüssen von allen anderen Schaltteilen.

5. Vorrichtung nach Anspruch 1, 2 oder 3, bei der jedes Schaltteil eines Schottky-Sperrschicht-Diode (SBD) hat, von der ein erster Anschluß mit dem Eingangsanschluß eines entsprechenden Worttreibers und ein zweiter Anschluß mit dem Wortleitungsselektionspegel-Schaltkreis (SLS) verbunden ist, gemeinsam mit den zweiten Anschlüssen von allen anderen Schaltteilen.

6. Vorrichtung nach Anspruch 1, 2 oder 3, bei der jedes Schaltteil einen Transistor (TD) umfaßt, dessen Basis und Kollektor miteinander verbunden sind, und dessen Kollektor mit dem Eingangsanschluß von einem entsprechenden Worttreiber verbunden ist, und dessen Emitter mit dem Wortleitungsselektionspegel-Schaltkreis (SLS) verbunden ist, gemeinsam mit den Emittern von allen anderen Schaltteilen.

7. Vorrichtung nach Anspruch 1, 2 oder 3, bei der jedes Schaltteil einen Transistor (TD) mit entsprechenden Widerständen ($R_1$, $R_2$) umfaßt, die jeweils zwischen einer Basis und einem Kollektor desselben und zwischen der Basis und einem Emitter desselben verbunden sind, wobei der Kollektor mit dem Eingangsanschluß von einem entsprechenden Worttreiber verbunden ist, und der Emitter mit dem Wortleitungsselektionspegel-Schaltkreis (SLS) verbunden ist, gemeinsam mit den Emittern von allen anderen Schaltteilen.

8. Vorrichtung nach einem der Ansprüche 2 bis 7, bei der der Wortleitungsselektionspegel-Schaltkreis (SLS) einen ersten Transistor ($T_2$) umfaßt, der einen Kollektor hat, der mit einer ersten Energieversorgungsleitung ($V_{CC}$) verbunden ist, einen Emitter, der mit einem Emitter eines zweiten Transistors ($T_1$) und mit einer Stromquelle ($I_{XW}$) verbunden ist, welche Stromquelle zwischen den Emittern des ersten und zweiten Transistors ($T_1$, $T_2$) und einer zweiten Energieversorgungsleitung verbunden ist, und eine Basis, die zum Empfang einer Referenzspannung ($V_R$) angeschlossen ist, wobei ein Kollektor des zweiten Transistors ($T_2$) gemeinsam mit den gleichrichtenden Schaltungen ($D_0$, $D_n$; $D_0$, $D_{15}$; SBD; TD; TD'; $R_1$, $R_2$) verbunden ist, und eine Basis des zweiten Transistors ($T_1$ angeschlossen ist, um ein Steuersignal (WE) zu empfangen, welches höher als die Referenzspannung ($V_R$) in einem Lesebetrieb und niedriger als die Referenzspannung ($V_R$) in einem Schreibbetrieb ist.

9. Vorrichtung nach einem der Ansprüche 2 bis 7, bei der der Wortleitungsselektionspegel-Schaltkreis (SLS) einen Transistor ($T_6$) umfaßt, der einen Kollektor hat, der mit einer ersten Energieversorgungsleitung ($V_{CC}$) verbunden ist, einen Emitter, der gemeinsam mit der Stromquelle ($I_{XW}$) verbunden ist, welche Stromquelle zwischen dem Emitter und einer zweiten Energieversorgungsleitung verbunden ist, und mit den gleichrichtenden Schaltungen ($D_0$, $D_n$), und eine Basis, die angeschlossen ist, um ein Steuersignal ($\overline{WG}$) zu empfangen, welches in einem Schreibbetrieb ein relativ hohes und in einem Lesebetrieb ein relativ neidriges ist.

10. Vorrichtung nach einem der Ansprüche 2 bis 7, bei der der von der Stromquelle ($I_{XW}$) gelieferte Strom in einem Lesebetrieb in die Last ($R_X$) eines ausgewählten Worttreibers fließt, während ein Strom ($I_X$) größer als der von der Stromquelle ($I_{XW}$) gelieferte Strom in die Last ($R_X$) eines nicht ausgewählten Worttreibers fließt.

11. Vorrichtung nach Anspruch 1, oder einem der Ansprüche 4 bis 7 in Verbindung mit Anspruch 1, bei der der Wortleitungsselektionspegel-Schaltkreis (SLS) einen ersten Transistor ($T_3$) umfaßt, der einen Kollektor hat, der mit einer ersten Energieversorgungsleitung ($V_{CC}$) verbunden ist, einen Emitter, der über einen ersten Widerstand ($R_1$) mit einem Kollektor eines zweiten Widerstands ($T_4$) und einer Basis eines dritten Widerstandes ($T_5$) verbunden ist, einen zweiten Widerstand ($R_2$), der zwischen der ersten Energieversorgungsleitung ($V_{CC}$) und einer Basis des zweiten Transistors ($T_4$) verbunden ist, und eine Diode (D'), die zwischen der Basis des zweiten Transistors ($T_4$) und einer zweiten Energieversorgungsleitung verbunden ist, wobei der Emitter des zweiten Transistors ($T_4$) mit der zweiten Energieversorgungsleitung verbunden ist, der Emitter des dritten Transistors ($T_5$) mit der zweiten Energieversorgungsleitung über einen dritten Widerstand ($R_3$) verbunden ist, der Kollektor des dritten

Transistors ($T_5$) gemeinsam mit den Schaltteilen verbunden ist, und die Basis des ersten Transistors ($T_3$) angeschlossen ist, um ein Steuersignal (WE) zu empfangen, welches in einem Lesebetrieb relativ hoch und in einem Schreibbetrieb relativ niedrig ist.

**Revendications**

1. Un dispositif de mémoire comportant un réseau de cellules de mémoire ($M_{S0}$, $M_{N0}$; $M_{00}$, $M_{n0}$; $MC_{00}$, $MC_{150}$) avec des lignes de mot ($W_S$, $W_N$; $W_0$, $W_n$; $WL_0$, $WL_n$; $W_0$, $W_{15}$) connectées aux cellules de mémoire, comprenant:

des circuits d'attaque de mot ($WD_S$, $WD_N$; $WD_0$, $WD_n$; $WD_0$, $WD_{15}$) destinés à attaquer des lignes de mot respectives du dispositif, qu'on peut faire fonctionner de façon que le potentiel ($V_{WS}$) d'une ligne de mot sélectionnée diffère de celui ($V_{WN}$) d'une ligne de mot non sélectionnée, sous la dépendance de signaux de sélection que des décodeurs de mot respectifs appliquent à des bornes d'entrée des circuits d'attaque de mot respectifs ($DEC_0$, $DEC_n$; $DEC_0$, $DEC_{15}$), les décodeurs de mot pouvant fonctionner de façon que le potentiel d'un signal de sélection ($V_{XS}$; $V_{X0}$, $V_{Xn}$; $V_{X0}$, $V_{X15}$) qui est appliqué à la borne d'entrée d'un circuit d'attaque de mot d'une ligne de mot sélectionnée diffère du potentiel d'un signal de sélection ($V_{XN}$; $V_{X0}$, $V_{Xn}$; $V_{X0}$, $V_{X15}$) qui est appliqué à la borne d'entrée d'un circuit d'attaque de mot d'une ligne de mot non sélectionnée, et

des moyens de commutation ($SW_S$, $SW_N$, SLS; $D_0$, $D_n$, SLS; $D_0$, $D_{15}$, SLS) connectés à des circuits d'attaque de mot respectifs ($WD_S$, $WD_N$; $WD_0$, $WD_n$, $WD_0$, $WD_{15}$) et conçus de façon que le potentiel d'un signal de sélection ($V_{XS}$) qui est appliqué à la borne d'entrée d'un circuit d'attaque de mot d'une ligne de mot sélectionnée diffère du potentiel d'un signal de sélection ($V_{XN}$) qui est appliqué à la borne d'entrée d'un circuit d'attaque de mot d'une ligne de mot non sélectionnée avec un écart plus grand dans une opération d'écriture que dans une opération de lecture, grâce à quoi la différence de potentiel entre une ligne de mot sélectionnée et une ligne de mot non sélectionnée est plus grande dans une opération d'écriture que dans une opération de lecture,

les moyens de commutation comprenant un ensemble d'éléments de commutation ($SW_S$, $SW_N$; $D_0$; $D_n$; $D_0$, $D_5$) connectés à des circuits d'attaque de mot respectifs, et

chaque circuit d'attaque de mot comprenant un transistor d'attaque ($T_{W0}$, $T_{Wn}$; $T_{W0}$, $T_{W15}$) ayant un collecteur connecté à une première ligne d'alimentation ($V_{CC}$), un émetteur connecté à l'une respective des lignes de mot, et une base, constituant la borne d'entrée du circuit d'attaque de mot, qui est connectée à la première ligne d'alimentation par l'intermédiaire d'une charge ($R_X$), et qui est connectée à l'élément respectif correspondant parmi les éléments de commutation, caractérisé en ce que

chaque élément de commutation comprend un circuit redresseur ($D_0$, $D_n$; $D_0$, $D_{15}$; SBD; TD; TD',

$R_1$, $R_2$) ayant des première et seconde bornes, avec la première borne connectée à la base du transistor d'attaque du circuit d'attaque de mot respectif,

et en ce que les moyens de commutation comprennent en outre un circuit de commutation de niveau de sélection de ligne de mot (SLS), connecté en commun aux secondes bornes de tous les éléments de commutation, et connecté à une seconde ligne d'alimentation, ce circuit de commutation pouvant commuter entre une condition, dans une opération de lecture, dans laquelle un courant circule à partir de l'élément de commutation connecté au circuit d'attaque de mot de la ligne de mot sélectionnée, et donc à partir d'une borne d'entrée de ce circuit d'attaque de mot, en traversant le circuit de commutation de niveau de sélection de ligne de mot, et une condition, dans une opération d'écriture, dans laquelle la circulation de ce courant ne peut pas avoir lieu.

2. Un dispositif selon la revendication 1, dans lequel le circuit de commutation de niveau de sélection de ligne de mot (SLS) comporte une source de courant ($I_{XW}$), de façon que dans une opération de lecture, les circuits redresseurs ($D_0$, $D_n$; $D_0$, $D_{15}$, SBD; TD; TD', $R_1$, $R_2$) et la source de courant forment un dispositif de commutation de courant.

3. Un dispositif selon la revendication 2 capable de fonctionner de façon que, dans une opération de lecture, la source de courant ($I_{XW}$) soit connectée aux circuits redresseurs ($D_0$, $D_n$; $D_0$, $D_{15}$; TD; TD', $T_1$, $R_2$).

4. Un dispositif selon la revendication 1, 2 ou 3, dans lequel chaque élément de commutation comprend une diode ($D_0$, $D_n$; $D_0$, $D_{15}$), dont une première borne est connectée à la borne d'entrée d'un circuit d'attaque de mot respectif ($WD_0$, $WD_n$; $WD_0$, $WD_{15}$) et dont une seconde borne est connectée au circuit de commutation de niveau de sélection de ligne de mot (SLS), en commun avec les secondes bornes de tous les autres éléments de commutation.

5. Un dispositif selon la revendication 1, 2 ou 3, dans lequel chaque élément de commutation comprend une diode à barrière de Schottky (SBD) dont une première borne est connectée à la borne d'entrée d'un circuit d'attaque de mot respectif et dont une seconde borne est connectée au circuit de commutation de niveau de sélection de ligne de mot (SLS), en commun avec les secondes bornes de tous les autres éléments de commutation.

6. Un dispositif selon la revendication 1, 2 ou 3, dans lequel chaque élément de commutation comprend un transistor (TD) ayant une base et un collecteur interconnectés, et avec le collecteur connecté à la borne d'entrée d'un circuit d'attaque de mot respectif et un émetteur connecté au circuit de commutation de niveau de sélection de ligne de mot (SLS), en commun avec les émetteurs de tous les autres éléments de commutation.

7. Un dispositif selon la revendication 1, 2 ou 3, dans lequel chaque élément de commutation comprend un transistor (TD) avec des résistances ($R_1$, $R_2$) respectivement connectées entre une base et un collecteur de ce transistor et entre la base et un émetteur du transistor, avec le collecteur connecté à la borne d'entrée d'un circuit d'attaque de mot respectif, et avec l'émetteur connecté au circuit de commutation de niveau de sélection de ligne de mot (SLS), en commun avec les émetteurs de tous les autres éléments de commutation.

8. Un dispositif selon l'une quelconque des revendications 2 à 7, dans lequel le circuit de commutation de niveau de sélection de ligne de mot (SLS) comprend un premier transistor ($T_2$) ayant un collecteur connecté à une première ligne d'alimentation ($V_{cc}$), un émetteur connecté à un émetteur d'un second transistor ($T_1$) et à la source de courant ($I_{XW}$), cette source de courant étant connectée entre les émetteurs des premier et second transistors ($T_1$, $T_2$) et une seconde ligne d'alimentation, et une base connectée de façon à recevoir une tension de référence ($V_R$), un collecteur du second transistor ($T_1$) étant connecté en commun aux circuits redresseurs ($D_0$, $D_n$; $D_0$, $D_{15}$; SBD; TD; TD'; $R_1$, $R_2$) et une base du second transistor ($T_1$) étant connectée de façon à recevoir un signal de commande (WE) qui est supérieur à la tension de référence ($V_R$) dans une opération de lecture et inférieur à la tension de référence ($V_R$) dans une opération d'écriture.

9. Un dispositif selon l'une quelconque des revendications 2 à 7, dans lequel le circuit de commutation de niveau de sélection de ligne de mot (SLS) comprend un transistor ($T_6$) ayant un collecteur connecté à une première ligne d'alimentation ($V_{cc}$), un émetteur connecté en commun à la source de courant ($I_{XW}$), cette source de courant étant connectée entre l'émetteur et une seconde ligne d'alimentation, et aux circuits redresseurs ($D_0$, $D_n$), et une base connectée de façon à recevoir un signal de commande ($\overline{WG}$) qui an niveau relativement haut dans une opération d'écriture et relativement bas dans une opération de lecture.

10. Un dispositif selon l'une quelconque des revendications 2 à 7, dans lequel le courant que fournit la source de courant ($I_{XW}$) circule dans la charge ($R_X$) d'un circuit d'attaque de mot sélectionné dans une opération de lecture, tandis qu'un courant ($I_X$) supérieur au courant que fournit la source de courant ($I_{XW}$) circule dans la charge ($R_X$) d'un circuit d'attaque de mot non sélectionné.

11. Un Dispositif selon la revendication 1, ou l'une quelconque des revendications 4 à 7, considérées comme rattachées à la revendication 1, dans lequel le circuit de commutation de niveau de sélection de ligne de mot (SLS) comprend un premier transistor ($T_3$) ayant un collecteur connecté à une première ligne d'alimentation ($V_{cc}$), un émetteur connecté par une première résistance ($R_1$) à un collecteur d'un second transistor ($T_4$) et à une base d'un troisième transistor ($T_5$), une seconde résistance ($R_2$) connectée entre

la première ligne d'alimentation (V<sub>cc</sub>) et une base du second transistor (T₄), et une diode (D') connectée entre la base du second transistor (T₄) et une seconde ligne d'alimentation, et en ce que l'émetteur du second transistor (T₄) est connecté à la seconde ligne d'alimentation, l'émetteur du troisième transistor (T₅) est connecté à la seconde ligne d'alimentation par l'intermédiaire d'une troisième résistance (R₃), le collecteur du troisième transistor (T₅) est connecté en commun aux éléments de commutation, et la base du premier transistor (T₃) est connectée de façon à recevoir un signal de commande (WE) qui a un niveau relativement haut dans une opération de lecture et relativement bas dans une opération d'écriture.

0 037 285

FIG. I.

1

FIG.2.

FIG.3.

FIG. 4.

FIG. 5.

Fig. 6.

Fig. 7.

FIG. 8.

FIG. 9A

FIG. 9B

FIG. 9C

FIG. 11.

*FIG. 10.*

*0 037 285*

# 0 037 285

FIG.12.

8

FIG. 13.